# EUROPEAN PATENT SPECIFICATION

(11) **EP 3 051 223 B1**
(45) Date of publication and mention of the grant of the patent: **08.11.2017**
(21) Application number: 15152918.7
(22) Date of filing: 28.01.2015
(51) Int. Cl.: H05B 3/50, F24H 3/04, B60H 1/22, F24H 9/00, F24H 9/18, H05K 1/02, B60H 1/00

(54) **Electric heating device**
Elektrische Heizungsvorrichtung
Dispositif de chauffage électrique

(43) Date of publication of application: 03.08.2016
(73) Proprietor: Mahle International GmbH, 70376 Stuttgart (DE)
(72) Inventor: Gries, Jean-Philippe, 68000 Colmar (FR)
(74) Representative: BRP Renaud & Partner mbB Rechtsanwälte Patentanwälte Steuerberater

(56) References cited:
- EP-A1- 1 157 867
- EP-A1- 1 395 098
- DE-B3-102011 089 539

## Description

The present invention relates to an electric heating device, particularly a booster heater for a vehicle, as described in the preamble of claim 1.

Electric heating devices are sufficiently well known from the prior art. They may be used for example to heat a fluid such as air. To this end, electric heating devices are usually equipped with electric heating elements. An example of such a heating device is described in DE 203 12 313 U1. This heating device comprises a tubular heating unit on which vanes with protruding embossments are provided for the purpose of transferring warmth to the fluid that is to be heated.

DE 39 34 547 A1 discloses another heating device of such kind that has a heating element in the form of a resistance heater for warming the fluid, the resistance heater being arranged rotatably in a housing through which a fluid can flow so that the transfer of heat to the fluid that is to be warmed is variable.

Such a heating device with electric resistance heating elements or PTC heating elements arranged in a flow chamber of a housing of the heating device in order to warm the fluid is known from DE 102 34 470 A1. The controller of the electrical heating elements, particularly the PTC heating elements, requires corresponding electrical components, which are accommodated in a controller housing and kept isolated from the flow chamber by a fluid. In this context, the electrical components for controlling the heating elements generate heat during operation, and this heat may arise in the form of power loss for example, particularly dissipated heat. Therefore, in order to ensure that the functional capability of the heating device is preserved, particularly that of the electrical components, it is essential to cool these components. For this purpose, a metal plate is attached to the side of the controller housing facing the flow chamber, fins project from the plate and the fluid to be heated flows round the fins. In this way, heat is exchanged between the electrical components and the fluid via the fins, including the metal plate and the controller housing, thereby cooling the electrical components.
In this context, it is conceivable to mount, and particularly solder, the electrical components on one or more printed circuit boards.
With heating devices of this kind, there is a need to provide the most effective cooling arrangement possible, and/or to improve the cooling effect. Document EP 1157867 A1 discloses the features of the preamble of claim 1. The present invention therefore addresses the problem of describing an improved or at least alternative embodiment of the heating device of the kind defined in the introduction, which is characterised in particular by improved cooling and/or greater efficiency and/or simplified operation.
This problem is solved according to the invention by the object of independent claim 1. Advantageous embodiments are the subject matter of the dependent claims.
The present invention is based on the general idea of cooling a printed circuit board on which are mounted electrical components for controlling a heating element of a heating device by means of a partial flow of a fluid that is to be heated, by diverting the flow of the fluid towards the printed circuit board. This is preferably done in such manner that as a consequence of the diversion at least some of the diverted fluid comes into physical contact with the printed circuit board. Then, heat is exchanged directly between the fluid and the printed circuit board, and this in turn improves and/or renders the cooling of the printed circuit board and/or the electrical components more efficient. The improved cooling of the printed circuit board and/or the electrical components also enables more efficient operation of the heating device. In particular, it thus becomes possible to use electrical components, particularly transistors, with lower on-resistances or R_{DS(on)}s. According to the inventive thought, the electric heating device comprises a housing that has a flow chamber through which a medium can flow in one flow direction, wherein the flow chamber is delimited by two opposing walls of the housing. The walls of the housing extend upwards, crossing the flow direction. In order to warm or heat the fluid that passes through the flow chamber, a heating element, preferably a PTC heating element that is controllable and is controlled by the electrical components, is provided inside the flow chamber. The electrical components are mounted on the printed circuit board, which is located inside the housing. It is further provided according to the invention that the heating device comprises a flow guidance element with a diversion section, which diverts the fluid towards the printed circuit board as it moves in the direction of flow. In this arrangement, the flow guidance element, particularly the diversion section, extends in an upward direction over a subsection of the flow chamber. In this way, only a part of the fluid moving in the direction of flow is diverted towards the printed circuit board.

The printed circuit board is arranged as required inside the housing and the printed circuit board delimits the flow chamber. This arrangement in particular enables more efficient cooling of the printed circuit board and/or of the electrical components.
The diversion of the fluid towards the printed circuit board in order to cool the printed circuit board has the further advantage that the exchange of heat between the printed circuit board and/or the electrical components by means of the fluid enables better warming of the fluid.
The flow guidance element, particularly the diversion section, also has the advantage that it causes irregularities in the flow of the fluid, particularly vortices, which have a positive impact on the exchange of heat between the fluid and the printed circuit board and/or the electrical components and/or an exchange of heat between the fluid and the heating element.

Variants in which the electrical components are located on the side of the printed circuit board facing the flow chamber are conceivable. In particular, this arrangement makes it possible to direct the fluid that is diverted towards the printed circuit board at the electrical components, particularly straight at the electrical components, thereby enabling improved and/or more efficient cooling thereof.

In principle, the flow guidance element may be positioned in any area of the flow chamber, provided it causes the fluid to be diverted towards the printed circuit board. In this respect, variants in which the flow guidance element is located at a distance from the printed circuit board, particularly from the electrical components, are advantageous. This makes it possible for the fluid to continue circulating after it has been diverted towards the printed circuit board and/or after the heat exchange with the printed circuit board and the electrical components, in a direction of flow that allows it to exit the flow chamber. In this context, variants in which the flow guidance element is arranged with a vertical height difference from the printed circuit board and/or the electrical components are particularly advantageous.

In order to improve the exchange of heat between the heating element and the fluid, a corrugated structure may be arranged inside the flow chamber. In this case, the corrugated structure is thermally connected to the heating element such that heat can be exchanged between the corrugated structure and the heating element. At the same time, fluid is able to pass through the corrugated structure in the direction of flow, that is to say the fluid to be warmed up flows through the corrugated structure in the direction of flow. The corrugated structure is also located with a vertical offset from the printed circuit board and/or the electrical components. In this context, it is particularly advantageous if the flow guidance element is disposed on the side of the corrugated structure facing the printed circuit board. In this way, only a part of the fluid circulating in the direction of flow is diverted towards the printed circuit board.

Embodiments are preferred in which the flow guidance element, particularly the diversion section thereof, is shaped for the purpose of diverting the fluid circulating in the direction of flow towards the printed circuit board. In this context, designs in which the diversion section is curved in the upward direction towards the printed circuit board have proven particularly advantageous. A diversion section that is curved in this way results in effective diversion of the fluid circulating in the direction of flow towards the printed circuit board. In particular, this makes it possible for the fluid to be diverted continuously and/or evenly.

The flow guidance element may be positioned in the flow chamber in any way required. For example, it is conceivable to fasten the flow guidance element in place on the housing. Such a retaining arrangement would enhance the stability of the flow guidance element in the flow chamber, so that the fluid circulating in the direction of flow can be diverted effectively and reliably. In this case, it is particularly conceivable that the guidance element is held in place on at least one such wall of the housing.

Embodiments in which the flow guidance element is constructed integrally with the housing have proven to be advantageous. In particular, this enables the number of individual, separate components of the heating device to be reduced. It is then also simpler to assemble the heating device, and/or production costs are lowered.

The corrugated structure and/or the housing and/or the flow guidance element may be manufactured from any materials. However, the corrugated structure is advantageously made from a metal substance in order to provide better heat exchange between the fluid and the corrugated structure and/or between the corrugated structure and the heating element.

It is also preferred if at least a part of the housing, particularly the walls thereof, is made from a plastic. Then, not only is the housing and thus also the heating device lightweight and/or inexpensive to make, it also provides corresponding electrical insulation for the heating device.

The flow guidance element may be made from any material. Metal materials are conceivable, for instance. An electrically insulating element may be arranged between the flow guidance element and such an adjacent electrical component or the printed circuit board. In this way, particularly electric currents between the flow guidance element and the printed circuit board or the electrical components may be avoided. In particular, electrical short circuits or the risk of such short circuits is at least reduced thereby.

It is also conceivable to make the flow guidance element from an electrically insulating material such as plastic. If the housing, particularly a wall thereof, is also made from plastic, it is further conceivable to produce the flow guidance element and the housing, particularly the wall, as a single part. For example, it is conceivable to create such a wall and the flow guidance element as an injection moulded part.

Of course, it is possible to provide a plurality of such diversion sections in the flow chamber. In this case, at least two such diversion sections may be arranged inside the flow chamber and at a distance from one another. In this way, the fluid is diverted towards the printed circuit board multiple times, leading to better cooling of the printed circuit board.

Alternatively or in addition to the preceding, it is possible to arrange a plurality of such diversion sections in the flow chamber so that they are separated crossing the flow direction and crossing the upward direction. This configuration causes the fluid to be diverted towards the printed circuit board at several points, to achieve improved cooling of the printed circuit board. In this context, the respective diversion section may be assigned with at least one other diversion section to a single such flow guidance element. This means that such a flow guidance element may also comprise two or more such diversion sections, which are arranged at intervals in the direction of flow. Of course, it is also conceivable that such a flow guidance element may comprise a plurality of such diversion sections that are separated crossing the upward direction and crossing the flow direction.

The heating device according to the invention is usable in any field. It is particularly conceivable to use the heating device as a booster heater. Accordingly, the heating device may be used in the air conditioning system of a motor vehicle, for example. In such a case, air is then warmed and/or used to cool the printed circuit board and the electrical components thereon.

In addition to the at least one flow guidance element it is possible to provide the housing with a sidewise opening arranged in the near area of the printed circuit board to allow a flow of the fluid through this opening. In this context it is further possible to arrange at least such a flow guidance element downstream the opening.

It is understood that the housing can comprise two or more such openings arranged sidewise the housing.

Further important features and advantages of the invention will be apparent from the subordinate claims, the drawing and accompanying description of the figures with reference to the drawing.

Naturally, the features described in the preceding and those that will be explained below can be used not only in the combinations described, but also in other combinations or as standalone features without exceeding the scope of the present invention.

Preferred embodiments of the invention are shown in the drawing and will be explained in greater detail in the following description, wherein identical or similar or functionally equivalent components are identified with the same reference sign.

In the following drawing:
- Fig. 1: is a diagrammatic representation of lengthwise section through a heating device according to the invention,
- Fig. 2: is a diagrammatic representation of transverse section through the heating device according to the invention.

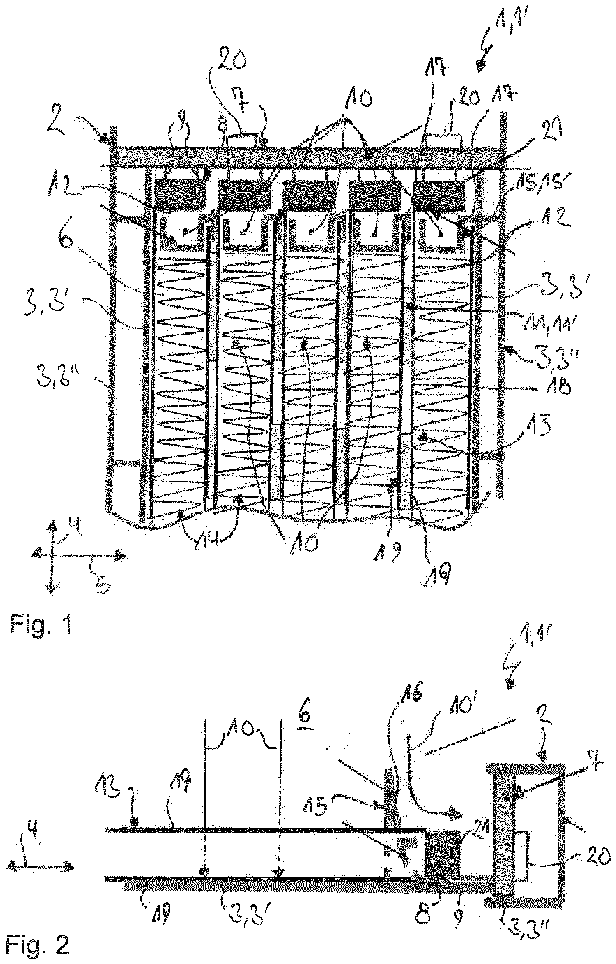

Figures 1 and 2 show a heating device 1, wherein Fig. 1 represents a lengthwise section through heating device 1 and Fig. 2 represents a transverse section through heating device 1. Heating device 1 is designed for use as a booster heater 1' for a motor vehicle -not shown here- and has a housing 2 with two opposing walls 3, which extend in an upward direction 4 and are arranged at a distance from each other in a transverse direction 5 crossing the upward direction 4. Walls 3 delimit a flow chamber 6 in housing 2. A further such wall 3 is arranged on the side of the wall 3 facing away from flow chamber 6, which further wall will be designated in the following as outer walls 3", whereas the walls 3 facing towards flow chamber 6 will be designated inner walls 3'. Accordingly, the respective inner wall 3' and the associated outer wall 3" are arranged at a distance from each other. A printed circuit board 7 extending in transverse direction 5 is arranged in the end face area of housing 2 in upward direction 4, and is held in place by outer walls 3". Clinch connections 8 are arranged on the side of printed circuit board 7 that faces towards flow chamber 6. Each clinch connection 8 is realised by using a contact sheet 13 and a connecting means 21 being electrically connected via the clinch connection8. Each connecting means 21 is soldered onto printed circuit board 7 via electrical contacts 9, wherein an electrical contact between the connecting means 21 and such a component 20 is established via at least such an electrical contact 9. Furthermore, in this way, clinch connections 8 are maintained at a distance from printed circuit board 7 in upward direction 4 and from each other in transverse direction 5.

Flow chamber 6 is designed to allow the passage of a fluid, for example air, in a flow direction 10 crossing upward direction 4 and crossing transverse direction 5. In order to warm up the fluid, a plurality of heating elements 11, particularly PTC heating elements 11' are arranged inside flow chamber 6 and are controlled by electrical components 20 arranged on the side of printed circuit board 7 opposing flow chamber 6 an electrically contacted to such an associated clinch connection 8 via at least such an electrical contact 9. Heating elements 11 are arranged with a space therebetween in upward direction 4 and in transverse direction 5, and can only be seen in Fig. 1. Each of the heating elements 11 that are adjacent in upward direction 4 are electrically connected to such an associated clinch connection 8 via the contact sheet 13 in such manner that they are controlled by at least such a component 20. As shown in the lengthwise section of Fig. 1, the respective contact sheet 13 has an L-shaped course, wherein a shorter flank 12 of contact sheet 13 contacts the corresponding connecting means 21 to build such a clinch connection 8 and to establish an electric connection between heat elements 11 and at least such a component 20. Each contact sheet 13 further comprises a longer flank 18 that comprises two distanced sheet layers 19, such that the associated heating elements 11 are surrounded by the layers 19.

A corrugated structure 14 is arranged between neighbouring longer flanks 19 in transverse direction 5, which corrugated structure extends in upward direction 4 and allows the passage of a fluid in flow direction 10. The respective corrugated structure 14 is thermally connected to at least one such heating element 11, particularly via one such associated longer flank 19, so heat is exchanged between corrugated structure 14 and the at least one such heating element 11. In this way, the fluid that flows in flow direction 10 through flow chamber 6 and corrugated structures 14 is heated by heating elements 11 via corrugated structures 14.

As may be seen particularly in Fig. 1, a flow guidance element 15 is arranged on the side of the respective corrugated structure 14 facing towards printed circuit board 7, and the flow guidance elements 15 are arranged at a distance from each other in transverse direction 5. The respective flow guidance element 15 extends in upward direction 4 and in transverse direction 5, and also in flow direction 10 over a subsection of flow chamber 6. Flow guidance elements 15 are also arranged at a distance in upward direction 4 from such a clinch connection 8 that is adjacent in upward direction 4. Thus, the fluid flowing in flow direction 10 is able to flow into the interspace between such a clinch connection 8 or the printed circuit board 7 and such a flow guidance element 15. The respective flow guidance element 15 comprises a diversion section 16, which diverts the fluid flowing in flow direction 10 towards printed circuit board 7, as is indicated by a curved arrow 10' (see also Fig. 2).

Fig. 2 shows that diversion section 16 is bent or curved in upward direction 4 towards printed circuit board 7, to ensure that the fluid flowing in flow direction 10 is diverted in a correspondingly homogeneous or continuous manner towards printed circuit board 7. In this way, the fluid that is diverted towards printed circuit board 7 by flow guidance element 15 comes into contact with printed circuit board 7 and/or at least one such clinch connection 8, thereby enabling effective cooling of printed circuit board 7 and/or clinch connections 8 to take place. In Fig. 2, the areas of flow guidance element 15 that would not be visible are indicated with a dashed line.

Fig. 1 shows that an electrical insulating element 17 is arranged between the respective flow guidance element 15 and the clinch connection 8 adjacent in upward direction 4, which insulating element 17 ensures that flow guidance element 15 is electrically insulated from clinch connections 8 and/or from contact sheet 13.

In principle, it is also conceivable that at least one such flow guidance element 15 is made from an electrically insulating material, such as plastic.

Housing 2, particularly the inner walls 3', are preferably made from plastic. In this context, it is evident particularly in Fig. 1 that the respective flow guidance element 15 is held in place in housing 2, particularly on inner wall 3'. Fig. 1 also shows that one of the flow guidance elements 15, 15' immediately adjacent to such an inner wall 3' is constructed integrally with the adjacent inner wall 3'. Then, flow guidance element 15, 15' and inner wall 3' may both be made from plastic, so that inner wall 3' and flow guidance element 15' may be produced as an injection moulded part.

Of course it is also conceivable to provide heating device 1 with such flow guidance elements 15, arranged at a distance from each other in flow direction 10. It is also conceivable that at least one such flow guidance element 15 comprises at least two such diversion sections 16 arranged at a distance from each other in flow direction 10.

## Claims

1. Electric heating device (1), particularly a booster heater (1') for a motor vehicle,
- having a housing (2) comprising a flow chamber (6) that allows the passage of a medium in a flow direction (10),
- wherein the housing (2) comprises two opposing walls (3) that extend in an upward direction (4) crossing the flow direction (10) and delimit the flow chamber (6),
- having an electric heating element (11) that is located inside the flow chamber (6) to heat a fluid that flows through the flow chamber (6),
- having a printed circuit board (7) that is furnished with at least one electric component (20) for controlling the heating element (11),
- wherein the printed circuit board (7) is located inside the housing (2),
- wherein the heating device (1) comprises a flow guidance element (15) with a diversion section (16) for diverting the fluid flowing in the flow direction (10) towards the printed circuit board (7),
- wherein the flow guidance element (15) extends over a subsection of the flow chamber (6) in upward direction (4),
**characterised in that**
the printed circuit board (7) delimits the flow chamber (6).

2. Heating device according to claim 1,
**characterised in that**
at least one such electric component (20) is arranged on the side of the printed circuit board (7) facing the flow chamber (6).

3. Heating device according to claim 1 or 2,
**characterised in that**
the flow guidance element (15) is arranged at a distance from the printed circuit board (7).

4. Heating device according to any one of claims 1 to 3,
**characterised in that**
a corrugated structure (14) that allows the passage of a medium in flow direction (10) is arranged inside flow chamber (6), and is thermally connected to the heater element (11) and located at a distance in the upward direction (4) from the printed circuit board (7), wherein the flow guidance element (15) is located on the side of the corrugated structure (14) facing the printed circuit board (7).

5. Heating device according to any one of claims 1 to 4,
**characterised in that**
the diversion section (16) is curved along the upward direction (4) towards
the printed circuit board (7).

6. Heating device according to any one of claims 1 to 5,
**characterised in that**
the flow guidance element (15) is held in place on the housing (2), particularly on such a wall (3) thereof.

7. Heating device according to any one of claims 1 to 6,
**characterised in that**
the flow guidance element (15) is constructed integrally with the housing (2), particularly with such a wall (3) thereof.

8. Heating device according to any one of claims 1 to 7,
**characterised in that**
an electrically insulating element (17) is arranged between the flow guidance element (15) and such an adjacent electrical component (20).

9. Heating device according to any one of claims 1 to 8,
**characterised in that**
at least two such diversion sections (16) are provided, and are arranged at a distance from each other in direction of flow (10).

10. Heating device according to any one of claims 1 to 9,
**characterised in that**
at least two such diversion sections (16) are provided, and are arranged at a distance from each other, in a direction crossing the direction of flow (10) and crossing the upward direction (4).

11. Heating device according to any one of claims 1 to 10,
**characterised in that**
the flow guidance element (15) diverts the fluid in such a manner that at least some of the diverted fluid comes into physical contact with the printed circuit board (7).

## Patentansprüche

1. Elektrische Heizvorrichtung (1), insbesondere Zusatzheizung (1'), für ein Kraftfahrzeug,
- mit einem Gehäuse (2), das eine Strömungskammer (6) aufweist, die den Durchtritt eines Mediums in einer Strömungsrichtung (10) ermöglicht,
- wobei das Gehäuse (2) zwei gegenüberliegende Wände (3) aufweist, die sich in einer Aufwärtsrichtung (4), die die Strömungsrichtung (10) kreuzt, erstrecken die Strömungskammer (6) begrenzen,
- mit einem elektrischen Heizelement (11), das in der Strömungskammer (6) angeordnet ist, um ein Fluid, das durch die Strömungskammer (6) strömt, zu erwärmen,
- mit einer Leiterplatte (7), die mit mindestens einem elektrischen Bauteil (20) zur Steuerung des Heizelementes (11) ausgestattet ist,
- wobei die Leiterplatte (7) innerhalb des Gehäuses (2) angeordnet ist,
- wobei die Heizvorrichtung (1) ein Strömungsführungselement (15) mit einem Umlenkabschnitt (16) zum Umleiten des in Strömungsrichtung strömenden Fluids (10) in Richtung zur Leiterplatte (7) aufweist,
- wobei sich das Strömungsführungselement (15) über einen Teilabschnitt der Strömungskammer (6) in Aufwärtsrichtung (4) erstreckt,
**dadurch gekennzeichnet, dass**
die Leiterplatte (7) die Strömungskammer (6) begrenzt.

2. Heizvorrichtung nach Anspruch 1,
**dadurch gekennzeichnet, dass**
mindestens eine solche elektrische Komponente (20) auf der der Strömungskammer (6) zugewandten Seite der Leiterplatte (7) angeordnet ist.

3. Heizvorrichtung nach Anspruch 1 oder 2,
**dadurch gekennzeichnet, dass**
das Strömungsführungselement (15) in einem Abstand von der Leiterplatte (7) angeordnet ist.

4. Heizvorrichtung nach einem der Ansprüche 1 bis 3,
**dadurch gekennzeichnet, dass**
eine gewellte Struktur (14), die Durchtritt eines Mediums in Strömungsrichtung (10) ermöglicht, in der Strömungskammer (6) angeordnet ist und thermisch mit dem Heizelement (11) verbunden ist und, in der Aufwärtsrichtung (4), in einem Abstand von der Leiterplatte (7) angeordnet ist, wobei das Strömungsführungselement (15) auf der der Leiterplatte (7) zugewandten Seite der gewellten Struktur (14) angeordnet ist.

5. Heizvorrichtung nach einem der Ansprüche 1 bis 4,
**dadurch gekennzeichnet, dass**
der Umlenkabschnitt (16) entlang der Aufwärtsrichtung (4) in Richtung zur Leiterplatte (7) hin gekrümmt ist.

6. Heizvorrichtung nach einem der Ansprüche 1 bis 5,
**dadurch gekennzeichnet, dass**
das Strömungsführungselement (15) an dem Gehäuse (2), insbesondere an einer solchen Wand (3) davon, gehalten wird.

7. Heizvorrichtung nach einem der Ansprüche 1 bis 6,
**dadurch gekennzeichnet, dass**
das Strömungsführungselement (15) einstückig mit dem Gehäuse (2), insbesondere mit einer solchen Wand (3) davon, ausgebildet ist.

8. Heizvorrichtung nach einem der Ansprüche 1 bis 7,
**dadurch gekennzeichnet, dass**
ein elektrisch isolierendes Element (17) zwischen dem Strömungsführungselement (15) und einem solchen benachbarten elektrischen Element (20) angeordnet ist.

9. Heizvorrichtung nach einem der Ansprüche 1 bis 8,
**dadurch gekennzeichnet, dass**
mindestens zwei solche Umlenkschnitte (16) vorgesehen sind und in Strömungsrichtung (10) in einem Abstand voneinander angeordnet sind.

10. Heizvorrichtung nach einem der Ansprüche 1 bis 9,
**dadurch gekennzeichnet, dass**
mindestens zwei solche Umlenkabschnitte (16) vorgesehen sind und in einer Richtung, die die Strömungsrichtung (10) kreuzt und die Aufwärtsrichtung (4) kreuzt, in einem Abstand voneinander angeordnet sind.

11. Heizvorrichtung nach einem der Ansprüche 1 bis 10,
**dadurch gekennzeichnet, dass**
das Strömungsführungselement (15) das Fluid so umleitet, dass zumindest ein Teil des umgeleiteten Fluids in physischen Kontakt mit der Leiterplatte (7) kommt.

## Revendications

1. Dispositif chauffant électrique (1), en particulier un chauffage d'appoint (1') pour un véhicule à moteur,
- ayant un logement (2) comprenant une chambre d'écoulement (6) qui permet le passage d'un milieu dans une direction d'écoulement (10),
- dans lequel le logement (2) comprend deux parois opposées (3) qui s'étendent dans une direction ascendante (4) croisant la direction d'écoulement (10) et délimitent la chambre d'écoulement (6),
- ayant un élément chauffant électrique (11) qui est situé à l'intérieur de la chambre d'écoulement (6) pour chauffer un fluide qui s'écoule à travers la chambre d'écoulement (6),
- ayant une carte de circuit imprimé (7) qui est pourvue d'au moins un composant électrique (20) pour commander l'élément chauffant (11),
- dans lequel la carte de circuit imprimé (7) est située à l'intérieur du logement (2),
- dans lequel le dispositif chauffant (1) comprend un élément de guidage d'écoulement (15) avec une section de déviation (16) pour dévier le fluide s'écoulant dans la direction d'écoulement (10) vers la carte de circuit imprimé (7),
- dans lequel l'élément de guidage d'écoulement (15) s'étend sur une sous-section de la chambre d'écoulement (6) dans une direction ascendante (4),
**caractérisé en ce que**
la carte de circuit imprimé (7) délimite la chambre d'écoulement (6).

2. Dispositif chauffant selon la revendication 1,
**caractérisé en ce que**
au moins un tel composant électrique (20) est agencé sur le côté de la carte de circuit imprimé (7) faisant face à la chambre d'écoulement (6).

3. Dispositif chauffant selon la revendication 1 ou 2,
**caractérisé en ce que**
l'élément de guidage d'écoulement (15) est agencé à distance de la carte de circuit imprimé (7).

4. Dispositif chauffant selon l'une quelconque des revendications 1 à 3,
**caractérisé en ce que**
une structure ondulée (14) qui permet le passage d'un milieu dans une direction d'écoulement (10) est agencée à l'intérieur de la chambre d'écoulement (6), et est connectée thermiquement à l'élément chauffant (11) et située à distance dans la direction ascendante (4) à partir de la carte de circuit imprimé (7), dans lequel l'élément de guidage d'écoulement (15) est situé sur le côté de la structure ondulée (14) faisant face à la carte de circuit imprimé (7).

5. Dispositif chauffant selon l'une quelconque des revendications 1 à 4,
**caractérisé en ce que**
la section de déviation (16) est courbée le long de la direction ascendante (4) vers la carte de circuit imprimé (7).

6. Dispositif chauffant selon l'une quelconque des revendications 1 à 5,
**caractérisé en ce que**
l'élément de guidage d'écoulement (15) est maintenu en place sur le logement (2), en particulier sur une telle paroi (3) de celui-ci.

7. Dispositif chauffant selon l'une quelconque des revendications 1 à 6,
**caractérisé en ce que**
l'élément de guidage d'écoulement (15) est construit d'un seul tenant avec le logement (2),
en particulier avec une telle paroi (3) de celui-ci.

8. Dispositif chauffant selon l'une quelconque des revendications 1 à 7,
**caractérisé en ce que**
un élément électriquement isolant (17) est agencé entre l'élément de guidage d'écoulement (15) et un tel composant électrique adjacent (20).

9. Dispositif chauffant selon l'une quelconque des revendications 1 à 8,
**caractérisé en ce que**
au moins deux telles sections de déviation (16) sont fournies, et sont agencées à distance l'une de l'autre dans une direction d'écoulement (10).

10. Dispositif chauffant selon l'une quelconque des revendications 1 à 9,
**caractérisé en ce que**
au moins deux telles sections de déviation (16) sont fournies, et sont agencées à distance l'une de l'autre, dans une direction croisant la direction d'écoulement (10) et croisant la direction ascendante (4).

11. Dispositif chauffant selon l'une quelconque des revendications 1 à 10,
**caractérisé en ce que**
l'élément de guidage d'écoulement (15) dévie le fluide de telle manière qu'au moins une partie du fluide dévié entre en contact physique avec la carte de circuit imprimé (7).
